# EUROPEAN PATENT APPLICATION

(11) **EP 2 154 939 A1**
(43) Date of publication of application: **17.02.2010**
(21) Application number: 07743323.3
(22) Date of filing: 14.05.2007
(51) Int. Cl.: H05K 3/46

(54) **WIRING BOARD AND METHOD OF MANUFACTURING THE SAME**

(71) Applicant: Ibiden Co., Ltd., Ogaki-shi, Gifu 503-8604 (JP)
(72) Inventor: TAKAHASHI, Michimasa, Ogaki-shi Gifu 503-8503 (JP); AOYAMA, Masakazu, Ogaki-shi Gifu 503-8503 (JP)
(74) Representative: Uchida, Kenji
(86) International application number: PCT/JP2007/059888
(87) International publication number: WO 2008/139612

(57) **Abstract**

Wiring board 19 is structured with first substrate 1, second substrate 2 having a smaller mounting area than that of first substrate 1, and base substrate 3 formed between first substrate 1 and second substrate 2. Also, wiring board 19 has vias 44 formed in at least either first substrate 1 or second substrate 2. In addition, wiring board 19 comprises interlayer groove portion 11 between first substrate 1 and second substrate 2. Interlayer groove portion 11 may be filled with at least one of gas, liquid, or solid material.

## Description

### Technical Field

The present invention relates to a wiring board formed by combining multiple boards each having a different mounting area, and a method of manufacturing such a wiring board.

### Background Art

Among electronic devices, some are preferred to be made compact and lightweight; especially, cell phones are expected to be made thin in addition to being made compact and lightweight. Also, wiring boards for use in cell phones are expected to be made compact, lightweight and thin.

However, if a wiring board is made thin, etc., it may not be rigid enough. For example, Patent Literature 1 discloses a technique to address insufficient rigidity of a wiring board. This technique relates to a wiring board having a reinforced portion formed by making an extended portion of a flexible substrate and folding the extended portion.

However, in this technique, when the extended portion is folded, a conductive pattern thereon is also folded, and the conductive pattern may eventually be disconnected. Further, since this technique uses a flexible substrate, there is a problem that the cost for manufacturing a wiring board is high. A reinforced portion can also be provided on the wiring board by using a rigid substrate instead of a flexible substrate and increasing the thickness of some parts of the wiring board. However, for example, when the wiring board using this technique is dropped, an arisen impact is transmitted to the wiring board, and wires connecting electronic components might eventually be disconnected.

In the meantime, wiring structures of electronic devices are expected to be made highly flexible. For example, Patent Literature 2 describes a technique to provide high flexibility in wiring structure. This publication discloses a printed wiring board having a first substrate with a second substrate laminated on the first substrate, where the contour of the second substrate is different from the contour of the first substrate.

Even if the technique disclosed in Patent Literature 2 is employed, wires connecting electronic components mounted on the printed board might eventually be disconnected, for example, when it is, e.g., dropped and exposed to an impact caused thereby.

Patent Literature 1: Unexamined Japanese Patent Application KOKAI Publication No. H5-152693
Patent Literature 2: WO 05/029934

### Disclosure of Invention

### Problem to be Solved by the Invention

The present invention is to solve the above subject matter; namely, to provide a wiring board and its manufacturing method, where a disconnection of the wiring that connects electronic components mounted on a wiring board may be prevented when the wiring board receives an impact from dropping or the like.

### Means for Solving the Problem

To achieve the above object, a wiring board according to the first aspect of the present invention is structured by laminating a first substrate, a second substrate having a smaller mounting area than that of the first substrate, and a base substrate formed between the first substrate and the second substrate. The wiring board has vias formed in at least either the first substrate or the second substrate.

Furthermore, to achieve the above object, a method of manufacturing a wiring board according to the second aspect of the present invention has a base-substrate forming step to form a base substrate, an insulation-layer forming step to form insulation layers positioned on both surfaces of the base substrate, a via forming step to form vias in the insulation layer(s), and a cutting step to form a first substrate and a second substrate having a smaller mounting area than that of the first substrate by cutting the insulation layer(s).

### Effect of the Invention

When a wiring board according to the present invention is,subject to an impact induced by dropping or the like, wires connecting electronic components mounted on the wiring board are not easily disconnected.

### Brief Description of Drawings

Fig. 1A is a side view illustrating a wiring board according to an embodiment of the present invention.
Fig. 1B is a plan view illustrating a wiring board according to an embodiment of the present invention.
Fig. 2 is a cross-sectional view illustrating a wiring board according to an embodiment of the present invention.
Fig. 3 is a cross-sectional view illustrating a wiring board according to an embodiment of the present invention.
Fig. 4 is a cross-sectional view illustrating a wiring board according to an embodiment of the present invention.
Fig. 5 is a cross-sectional view illustrating a wiring board according to an embodiment of the present invention.
Fig. 6 is a cross-sectional view illustrating a wiring board according to an embodiment of the present invention.
Fig. 7A is a process chart to describe a manufacturing step of a wiring board according to an embodiment of the present invention.
Fig. 7B is a process chart to describe a manufacturing step of a wiring board according to an embodiment of the present invention.
Fig. 7C is a process chart to describe a manufacturing step of a wiring board according to an embodiment of the present invention.
Fig. 7D is a process chart to describe a manufacturing step of a wiring board according to an embodiment of the present invention.
Fig. 7E is a process chart to describe a manufacturing step of a wiring board according to an embodiment of the present invention.
Fig. 7F is a process chart to describe a manufacturing step of a wiring board according to an embodiment of the present invention.
Fig. 7G is a process chart to describe a manufacturing step of a wiring board according to an embodiment of the present invention.
Fig. 7H is a process chart to describe a manufacturing step of a wiring board according to an embodiment of the present invention.
Fig. 7I is a process chart to describe a manufacturing step of a wiring board according to an embodiment of the present invention.
Fig. 7J is a process chart to describe a manufacturing step of a wiring board according to an embodiment of the present invention.
Fig. 7K is a process chart to describe a manufacturing step of a wiring board according to an embodiment of the present invention.
Fig. 7L is a process chart to describe a manufacturing step of a wiring board according to an embodiment of the present invention.
Fig. 7M is a process chart to describe a manufacturing step of a wiring board according to an embodiment of the present invention.
Fig. 7N is a process chart to describe a manufacturing step of a wiring board according to an embodiment of the present invention.
Fig. 7O is a process chart to describe a manufacturing step of a wiring board according to an embodiment of the present invention.
Fig. 7P is a process chart to describe a manufacturing step of a wiring board according to an embodiment of the present invention.
Fig. 7Q is a process chart to describe a manufacturing step of a wiring board according to an embodiment of the present invention.
Fig. 7R is a process chart to describe a manufacturing step of a wiring board according to an embodiment of the present invention.
Fig. 7S is a process chart to describe a manufacturing step of a wiring board according to an embodiment of the present invention.
Fig. 7T is a process chart to describe a manufacturing step of a wiring board according to an embodiment of the present invention.
Fig. 7U is a process chart to describe a manufacturing step of a wiring board according to an embodiment of the present invention.
Fig. 7V is a process chart to describe a manufacturing step of a wiring board according to an embodiment of the present invention.
Fig. 8 is a cross-sectional view illustrating a wiring board according to an embodiment of the present invention.
Fig. 9A is a process chart to describe a manufacturing step of a wiring board according to an embodiment of the present invention.
Fig. 9B is a process chart to describe a manufacturing step of a wiring board according to an embodiment of the present invention.
Fig 10 is a cross-sectional view illustrating a wiring board according to an embodiment of the present invention.
Fig. 11 is a cross-sectional view illustrating a wiring board according to an embodiment of the present invention.
Fig. 12 is a cross-sectional view illustrating a wiring board according to an embodiment of the present invention.

### Explanation of Reference Numerals

- 1: first substrate
- 2: second substrate
- 3: base substrate
- 5: opening
- 7: keypad
- 8: electronic chip
- 9: solder
- 10: gold pad
- 11: interlayer groove portion
- 12: adhesion prevention layer
- 13: multi-layer section
- 14: fewer-layer section
- 19: wiring board according to the present invention
- 44: via
- 51: copper foil
- 52: dummy core
- 54: copper foil
- 55: core material
- 61: copper foil
- 62: prepreg
- 63: through-hole
- 71: copper foil
- 72: epoxy resin
- 81: epoxy resin
- 82: copper foil
- 83: solder-resist
- 91: gold plating
- 92: electronic component

### Best Mode for Carrying Out the Invention

### (First embodiment of a wiring board according to a specific example of the present invention)

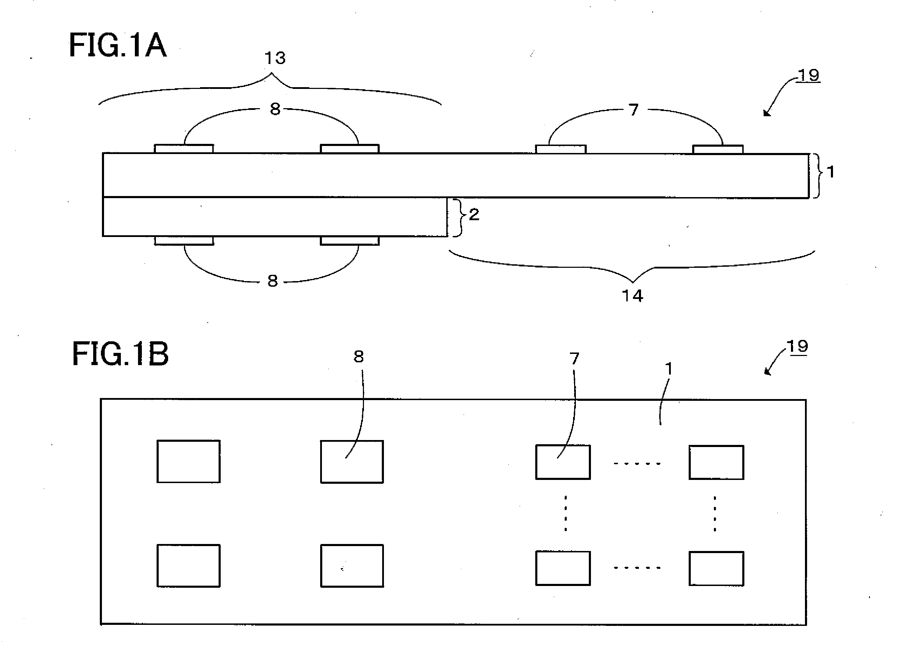

In the following, an embodiment of a wiring board according to a specific example of the present invention is described with reference to the drawings.
As shown in Fig. 1A, wiring board 19 according to a specific example of the present invention has a different thickness of one edge from that of the other edge. The number of layers in the section having a different thickness differs from the number of layers in the thinner section. Namely, wiring board 19 has thick multi-layer section 13 and relatively thin fewer-layer section 14. Multi-layer section 13 is formed by laminating two layers of first substrate 1 and second substrate 2. Fewer-layer section 14 has first substrate 1 which is extended from multi-layer section 13.

As shown in Figs. 1A and 1B, first substrate 1 and second substrate 2 have the same width and different lengths, and one end of first substrate 1 and one end of second substrate 2 are aligned. First substrate 1 and second substrate 2 are each made of non-pliable base material such as epoxy resin.

On the surfaces (mounting surfaces) of first substrate 1 and second substrate 2, connecting pads to connect electronic components are formed; on the surfaces (mounting surfaces) and inner surfaces of first substrate 1 and second substrate 2, wiring patterns to structure electrical circuits are formed.

On the mounting surfaces of first substrate 1 and second substrate 2, electronic components 7, 8 are arranged and connected to connecting pads according to their requirements. Electronic components 7, 8 are connected with each other through connecting pads and wiring patterns.

Wiring board 19 is placed, for example, in the casing of a cell phone device. In such a circumstance, electronic component 7 placed in fewer-layer section 14 is structured, for example, with the keypad of a keyboard; and electronic component 8 placed in multi-layer section 13 is structured with an electronic chip, IC module, functional components and others. Also, in the stepped portion formed by multi-layer section 13 and fewer-layer section 14, for example, a thin-type battery is placed.

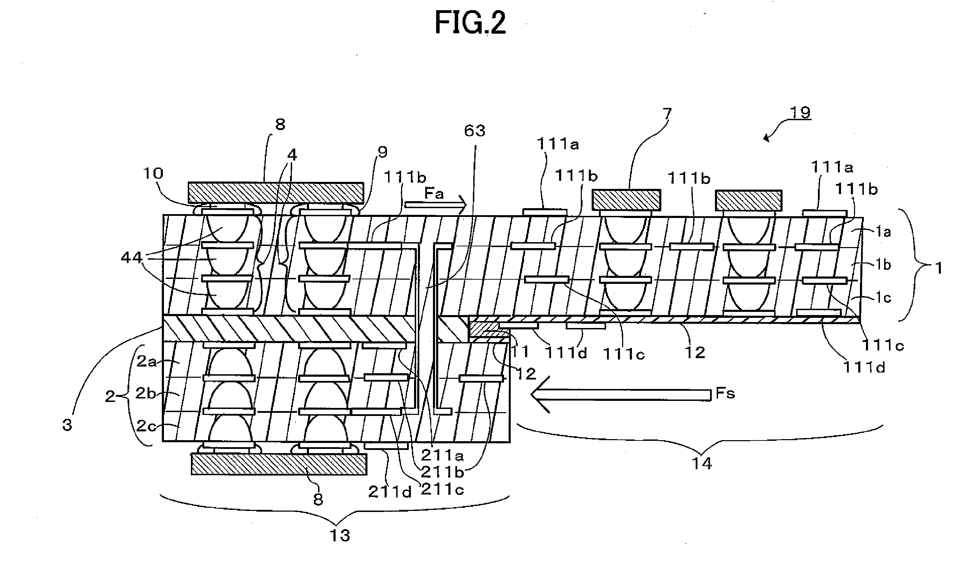

Next, a detailed structure of wiring board 19 having the above overall structure is described referring to Fig. 2. As illustrated, first substrate 1 and second substrate 2 are laminated by sandwiching base substrate 3 between them. One end (the left end as illustrated in the drawing) of base substrate 3 is made to be flush with first substrate 1 and second substrate 2. Base substrate 3 is made of a highly rigid material such as glass epoxy resin. Base substrate 3 is made 50-100 µm, preferably about 100 µm.

Base substrate 3 is formed to be shorter than second substrate 2, and between first substrate 1 and second substrate 2, a groove (hereinafter referred to as "interlayer groove portion") 11 is formed. Interlayer groove portion 11 is an aperture. The groove may be filled with elastic material such as silicon gel and silicon oil or viscous material or others. When wiring board 19 receives an impact from dropping, the groove aperture or silicon gel or silicon oil that is filled in the interior portion of the groove cushions the impact as a shock-absorbing layer. Therefore, by being structured as such, drop impact resistance may be improved.

First substrate 1 has a structure of laminated multiple insulation layers (1a, 1b, 1c). Each insulation layer is made of epoxy resin or the like with a thickness approximately 10 µm-60 µm. On the upper surface of insulation layer (1a), between epoxy-resin layers (1a) and (1b), between insulation layers (1b) and (1c) and on the lower surface of insulation layer (1c), wiring patterns (111a, 111b, 111c, 111d) are each formed. Each wiring pattern (111a, 111b, 111c, 111d) electrically connects required portions inside the circuit substrate.

Second substrate 2 also has a structure of laminated multiple insulation layers (2a, 2b, 2c) made of epoxy resin or the like with a thickness of approximately 10 µm-60 µm. On the lower surface of insulation layer (2a), between epoxy-resin layers (2a) and (2b), between insulation layers (2b) and (2c) and on the upper surface of insulation layer (2c), wiring patterns (211a, 211b, 211c, 211d) are each formed. Each wiring pattern (211a, 211b, 211c, 211d) electrically connects required portions inside the circuit substrate.

On the exposed portion of the lower surface of first substrate 1 and the exposed portion of the upper surface of the second substrate, adhesion prevention layers 12 are formed as a protective insulation layer. At the stepped portion created when laminating first substrate 1 and second substrate 2, conductive pattern (111d) is formed. Also, to the right of conductive pattern (111d) formed at the stepped portion, conductive pattern (111d) is formed.

Keypad 7 is placed on the conductive pattern formed on the surface of fewer-layer section 14. Further, using solder 9, electronic chip 8 is anchored and connected to wiring patterns and built-up via 4 through connecting pads 10. For solder 9, Sn/Ag/Cu was used.

Moreover, through-hole 63 is formed, penetrating base substrate 3 and connecting wiring pattern (111b) of first substrate 1 and wiring pattern (211c) of second substrate 2. The inner surface of through-hole 63 is plated to electrically connect wiring patterns. The inner portion of plated through-hole 63 may be filled with resin such as epoxy resin.

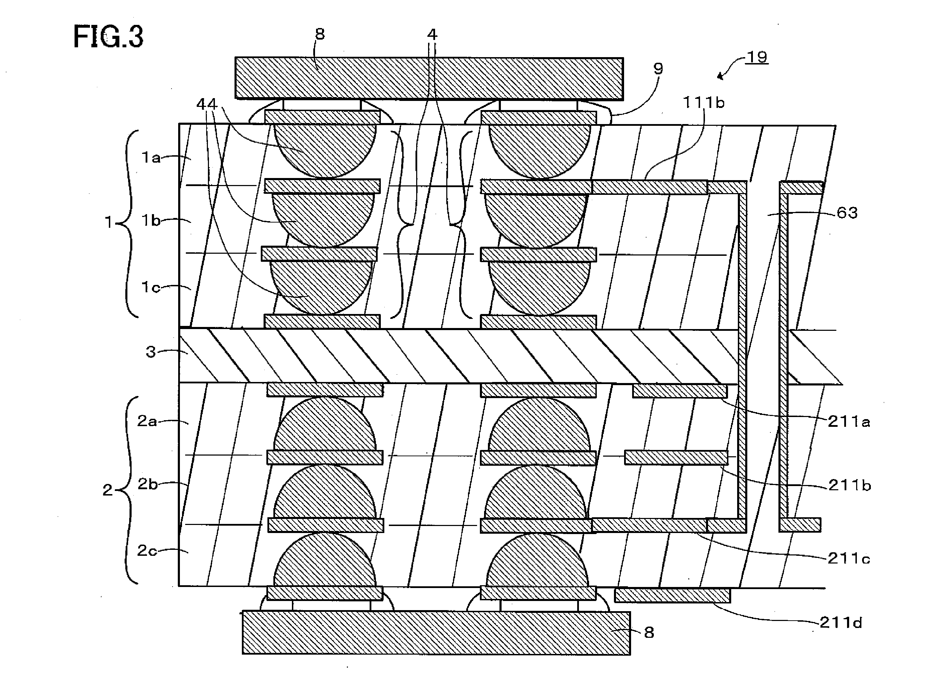

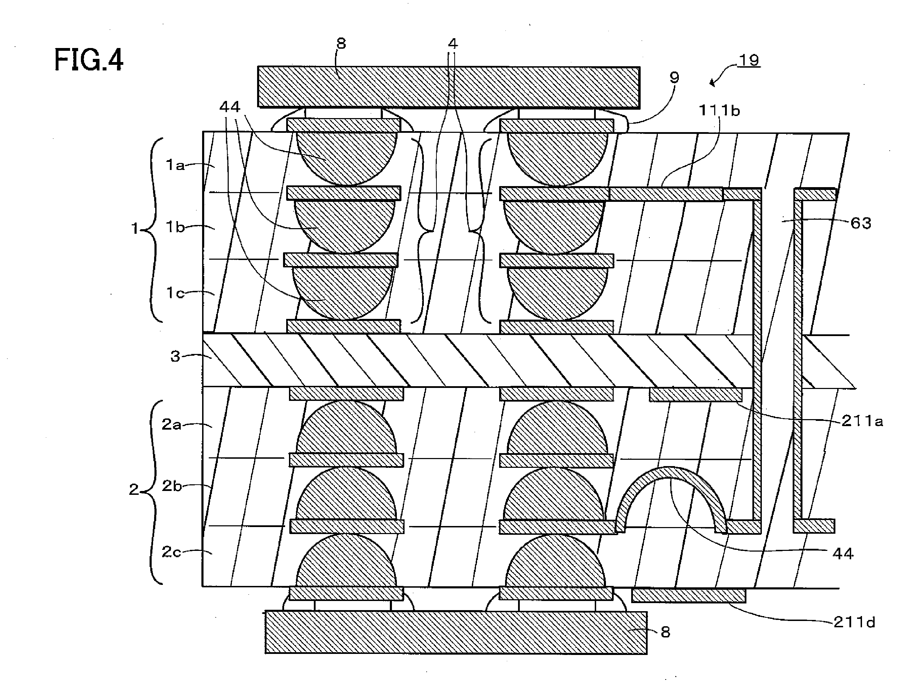

In first substrate 1 and second substrate 2, multiple built-up vias 4 are formed. Built-up vias 4 are structured by stacking vias 44 formed in each insulation layer (1a-1c, 2a-2c). Built-up vias 4 connect required portions of wiring patterns (111a-111d) and also connect required portions of wiring patterns (211a-211d). On the inner surface of each via 44 forming built-up via 4, a conductive layer made by copper plating or the like is formed. As shown in Fig. 3, the interior portion of each via 44 is filled with conductor such as copper. However, as shown in Fig. 4, the interior portion of via 44 may be filled with resin such as epoxy resin.

Wiring board 19 having the above structure, for example, transmits operational signals from keypad 7 to an IC chip through built-up vias 4, wiring patterns (111a-111d) and through-hole 63, and the signals are then processed at the IC chip. By doing so, varieties of signal processing may be conducted.

Also, as described above, wiring board 19 is structured with multi-layer section 13 and fewer-layer section 14 and has a stepped portion. And at the lower portion of fewer-layer section 14, a large-volume component such as a cell-phone battery may be placed.

Base substrate 3 is made of highly rigid material such as glass-epoxy resin. Multi-layer section 13, because of base substrate 3 placed there, is highly rigid compared with fewer-layer section 14. On the other hand, fewer-layer section 14 is relatively flexible compared with multi-layer section 13. Thus, it is possible to place electronic components according to the reliability level they require when being placed.

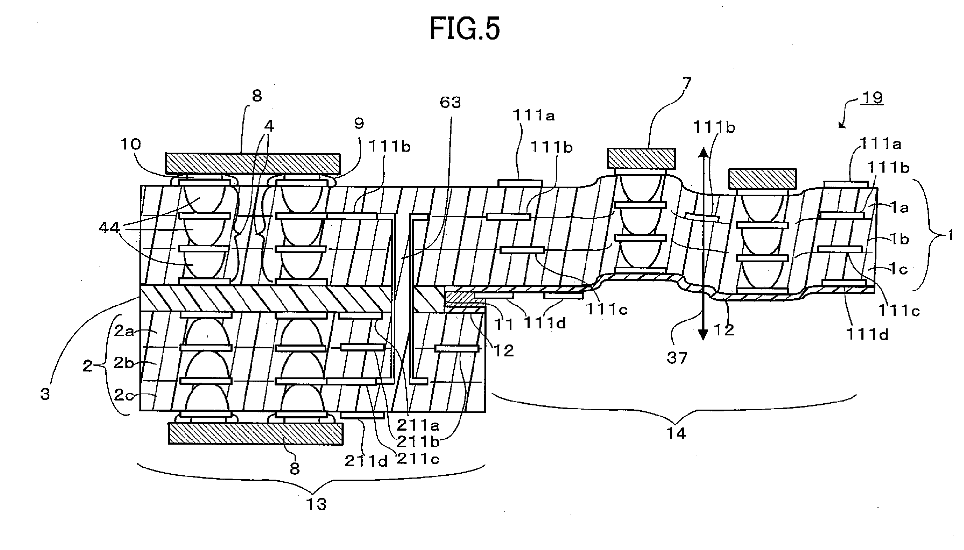

Also, for example, when the electronic device is dropped and an impact or the like is exerted on wiring board 19, due to the relative flexibility of fewer-layer section 14 compared with multi-layer section 13, fewer-layer section 14 vibrates as shown by arrow 37 in Fig. 5. Since portions of fewer-layer section 14 vibrate, the impact from dropping or the like is converted to vibrational kinetic energy, and the impact is absorbed accordingly. As a result, a disconnection of the wiring connecting the electronic components mounted on wiring board 19 may be prevented.

Also, built-up via 4 is structured with a stacked via made by laminating multiple vias 44. By making such a stacked interlayer connection structure, the wiring length may be shortened, and thus preferable for mounting electronic components requiring large amount of electricity.

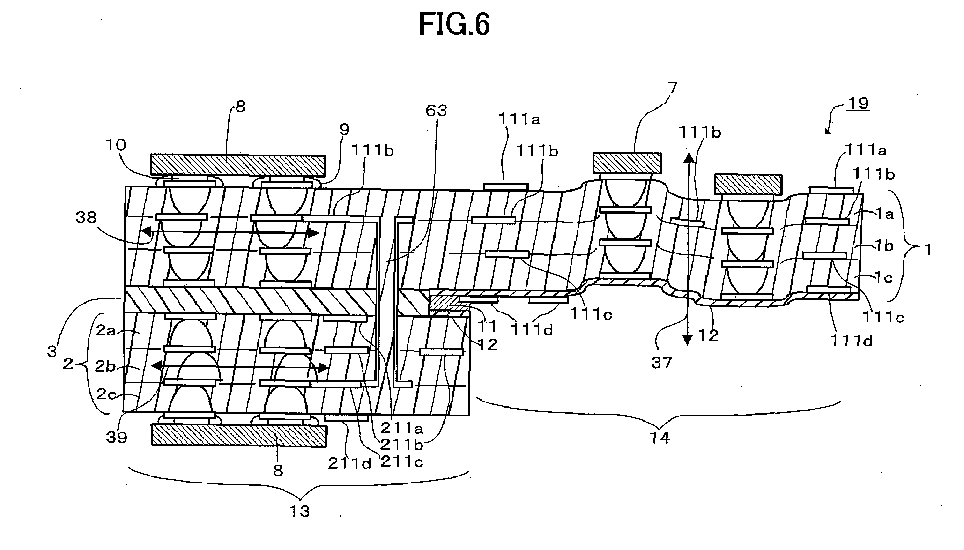

Moreover, built-up via 4 has a certain degree of mobility. Therefore, for example, when the electronic device is dropped and an impact is exerted on wiring board 19, the built-up via 4 may absorb the impact by its deflection as shown by arrows 38, 39 in Fig. 6. As a result, a disconnection of the wiring connecting the electronic components mounted on wiring board 19 may be prevented.

In addition, if solid material or the like is filled in interlayer groove portion 11, when the impact from dropping or the like is exerted on the wiring board, interlayer groove portion 11 cushions the impact as a buffer layer. Accordingly, when interlayer groove portion 11 is formed, by improving drop impact resistance, disconnection of the wiring connecting the electronic components mounted on the wiring board may be prevented.

Also, in certain circumstances, two wiring boards of the present invention may be combined and sold in such a way that each fewer-layer section 14 is closely placed. Here, if a conductive pattern is formed at the stepped portion created when first substrate 1 and second substrate 2 are laminated, in the circumstance when a user or the like cuts the combined wiring boards of the present invention and uses them separately, warping of the wiring boards may be prevented. Namely, multi-layer section 13, because of base substrate 3 deposited there, is rigid compared with fewer-layer section 14. Thus, when a user or the like cuts the combined wiring boards of the present invention and uses them separately, warping does not occur at multi-layer section 13. On the other hand, fewer-layer section 14 is flexible compared with multi-layer section 13. Thus, when a user or the like cuts the combined wiring boards of the present invention and uses them separately, warping could possibly occur at fewer-layer section 14, especially at the stepped portion of fewer-layer section 14 created when first substrate 1 and second substrate 2 are laminated. However, if a conductive pattern is formed at the stepped portion, even when a user or the like cuts the combined wiring boards of the present invention and uses them separately, warping may be prevented.

### (Method of manufacturing a wiring board according to a specific example of the present invention)

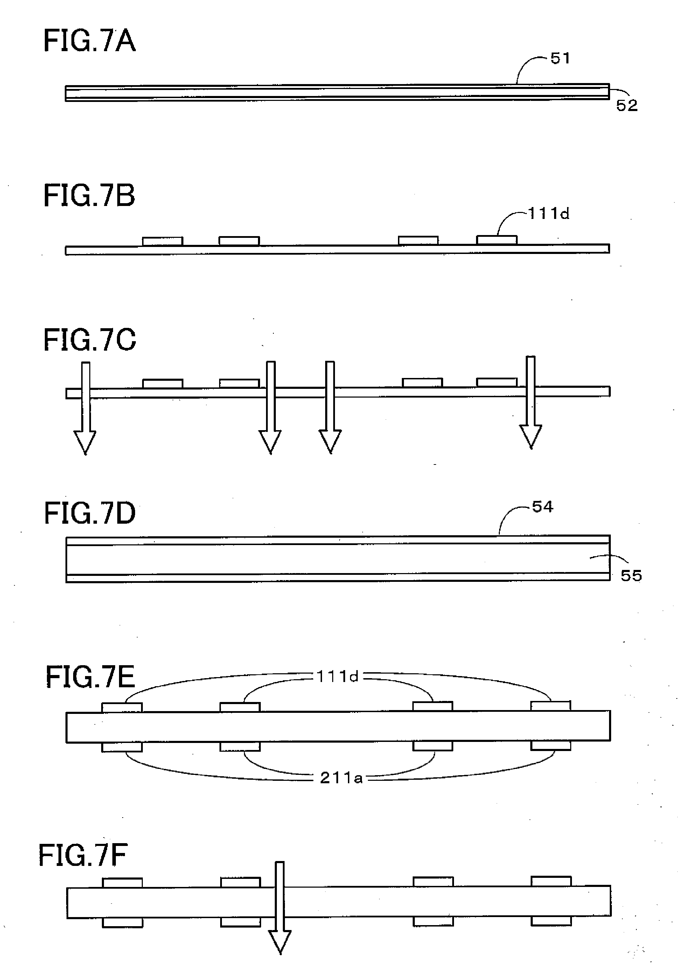

In the following, a method of manufacturing wiring board 19 according to the present invention is described.
First, as shown in Fig. 7A, dummy core 52 which later forms adhesion prevention layer 12 is prepared. Dummy core 52 is, for example, formed with a C-stage epoxy resin. On dummy core 52, copper foil 51 is deposited.

Next, as shown in Fig. 7B, by patterning copper foil 51, conductive pattern (111d) is formed at a predetermined position.

Then, as shown by arrows in Fig. 7C, dummy core 52 is cut by a laser or the like to adjust its length to a length preferred for use in wiring board 19.

Meanwhile, as shown in Fig. 7D, core 55, which later functions as base substrate 3, is prepared. Core 55 is made, for example, of highly rigid material such as glass-epoxy resin. On both surfaces of core 55, copper foil 54 is deposited.

Next, as shown in Fig. 7E, by patterning copper foil 54, conductive patterns (111d, 211a) are formed to structure wiring patterns.

Next, as shown by an arrow in Fig. 7F, in core 55" a hole to insert dummy core 52 is formed by using a laser or the like.

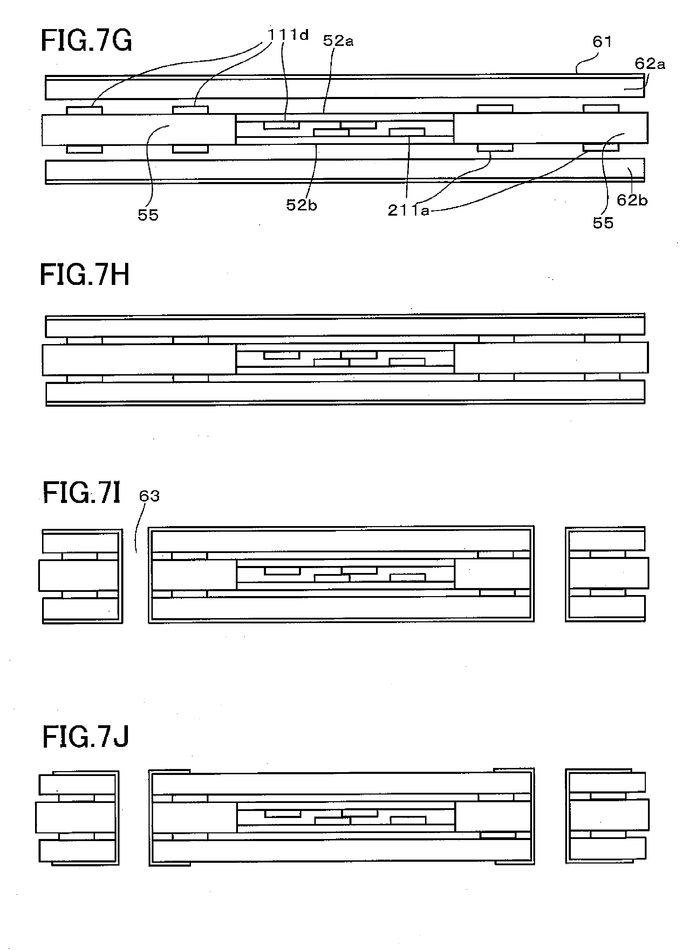

Next, as shown in Fig. 7G, cut-out dummy cores (52a, 52b) are placed in such a way that conductive pattern (111d) and conductive pattern (211 a) are laminated facing inward. Then, laminated dummy cores (52a, 52b) and cut-out core 55 are horizontally connected. In the following, on the top and bottom of dummy cores (52a, 52b) and core 55, prepreg (62a, 62b) are laminated. Furthermore, low-flow prepreg impregnated with low-flow epoxy resin is preferred for prepreg (62a, 62b). Then, on the surfaces of prepreg (62a, 62b), copper foils (61a, 61b) are deposited.

Next, as shown in Fig. 7H, the laminated layers shown in Fig. 7G are pressure-pressed. Pressure pressing is conducted, for example, by hydraulic pressure using hydraulic pressing equipment, under conditions of temperature of 200°C, pressure of 40 kgf, and pressing time of three hours. By doing so, resin leaks from the prepreg, and the prepreg and core material will be integrated. At this time, since dummy core 52 is made of a C-stage epoxy resin, the materials in dummy core 52 are not integrated with each other. Furthermore, vacuum pressing may be employed instead of hydraulic pressing for pressure pressing. By vacuum pressing, bubbles may be prevented from being mixed into the resin that structures the insulation layers. Vacuum pressing is conducted, for example, for an hour. Peak heating temperature is set, for example, at 175°C; and vacuum-pressing pressure is set, for example, at 3.90 x 10⁶ [Pa].

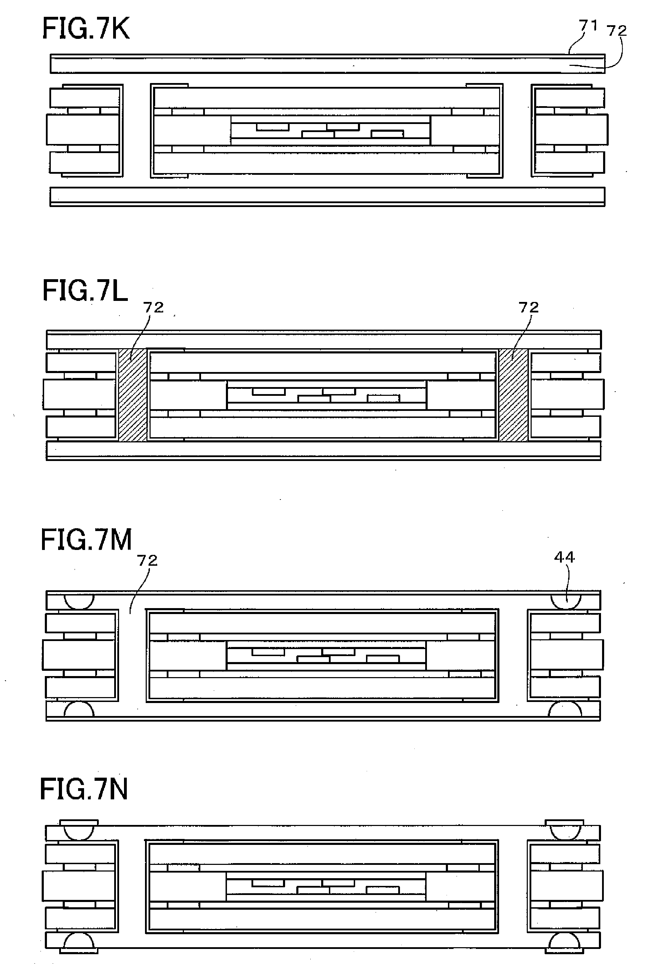

Next, in the laminated layer shown in Fig. 7H, holes are bored using a drill. By doing so, as shown in Fig. 7I, through-holes 63 are formed.
When forming an IVH (Interstitial Via Hole), a CO₂ laser is beamed from CO₂ laser processing equipment to bore a hole in insulation layers. Then, at a via-forming step described later referring to Fig. 7M, by stacking vias at both ends of the bored hole, an IVH is formed.

Next, as shown in Fig. 7J, by removing the unnecessary portions of copper foil 61, an inner-layer pattern is formed.

Next, as shown in Fig. 7K, epoxy resin 72 is further laminated to form inner layers. On both surfaces of epoxy resin 72, copper foil 71 is deposited.

Next, as shown in Fig. 7L, after the lamination shown in Fig. 7K, pressure pressing is conducted. Pressure pressing may be conducted, for example, by hydraulic power using hydraulic pressing equipment, or may be conducted by vacuum pressing. Portions of epoxy resin 72 are filled in through-holes 63.

Next, as shown in Fig. 7M, vias 44 are formed. Namely, in epoxy resin 72 made of insulation resin, via-hole openings are formed. Those openings may be formed by beaming a laser. And, to remove resin residue remaining on the side and bottom surfaces of the openings formed by beaming a laser, desmear treatment is carried out. The desmear process is performed using an oxygen plasma discharge treatment, a corona discharge treatment, an ultra-violet laser treatment or an excimer laser treatment. In the openings formed by beaming a laser, conductive material is filled to form filled-via holes. For conductive material, a conductive paste or metal plating formed by electrolytic plating process is preferred. For example, vias 44 are filled with conductor such as copper plating. To reduce the manufacturing cost and improve productivity by simplifying the filled-via forming step, filling with a conductive paste is preferred. For example, a conductive paste (such as thermo-set resin containing conductive particles) may be printed by screen-printing, filled in vias 44 and set. By filling the inner portion of vias 44 with the same conductive paste material, connection reliability when thermo-stress is exerted on vias 44 may be improved. On the other hand, regarding connection reliability, metal plating formed by an electrolytic plating process is preferred. Especially, electrolytic copper plating is preferred.

Next, as shown in Fig. 7N, by removing the unnecessary portions of copper foils 71, inner-layer patterns are formed.

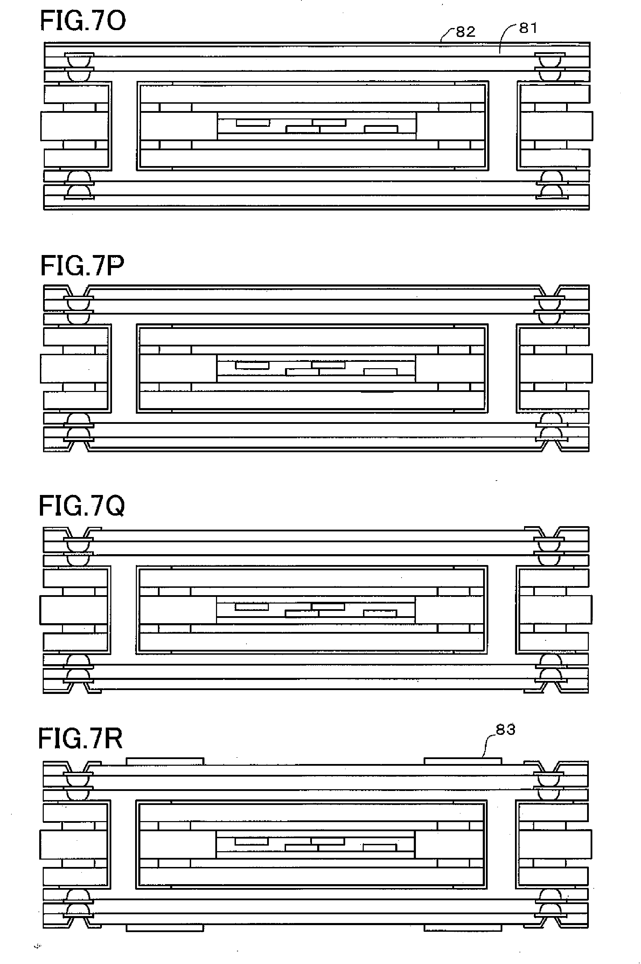

Next, as shown in Fig. 7O, after inner layers and vias are further formed, epoxy resin 81 is laminated to form outer layers. On both surfaces of epoxy resin 81, copper foil 82 is deposited. Here, a copper foil sheet with resin (Resin Cupper Film: RCF) may be deposited and pressed.

Next, as shown in Fig. 7P, in the RCF, vias are formed. In the following, using copper plating or the like, the interior portions of the vias are filled with conductor. Also, according to requirements, by patterning the surface copper foil, a conductive pattern is formed.

Next, as shown in Fig. 7Q, by removing the unnecessary portions of copper foils 82, outer-layer patterns are formed.

Next, as shown in Fig. 7R, solder-resists 83 are formed. Here, the solder resist indicates heat-resistant coating material, and covers the portions so that, when applying solder, the solder does not adhere thereto. For solder-resist varieties, photo-setting type solder resist and thermo-setting type solder resist may be used. For a coating method, a screen-printing method or curtain-coating method may be used.

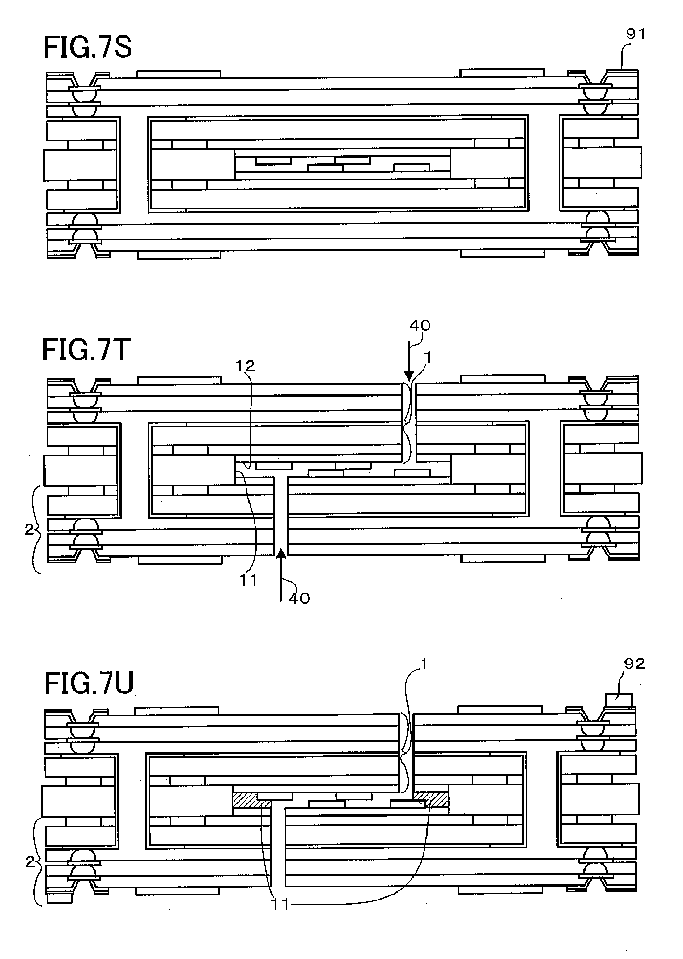

Next, as shown in Fig. 7S, to protect outer-layer patterns, gold plating 91 is performed by chemical plating. Other than chemical plating, methods such as fusion plating and electrical plating may be used. Moreover, other than gold plating, alloy plating may be used.

Next, as shown by arrows 40 in Fig. 7T, laser beams from laser processing equipment, such as CO₂ laser, are irradiated using conductive patterns (111d) as a stopper to cut insulation layers and the copper foil sheet with resin (RCF). Here, the thickness of conductive patterns (111d) is preferred to be made approximately 5-10 µm: If too thin, laser beams penetrate the pattern; and if too thick, conductive patterns with a fine line width are difficult to form.
Meanwhile, by laser cutting as shown in Fig. 7T, interlayer groove portions 11 are also formed. Namely, by laser cutting, interlayer groove portions 11 are formed, each interlayer groove portion 11 consists of adhesion prevention layers 12 of first substrate 1 and second substrate 2 as groove side-walls, and one surface of base substrate 3 as groove bottom-wall.

Lastly, as shown in Fig. 7U, electronic components 92 are mounted. Electronic components 92 are an electronic chip 8 and keypad 7. Further, in interlayer groove portions 11, elastic material, viscous material or the like may be filled.

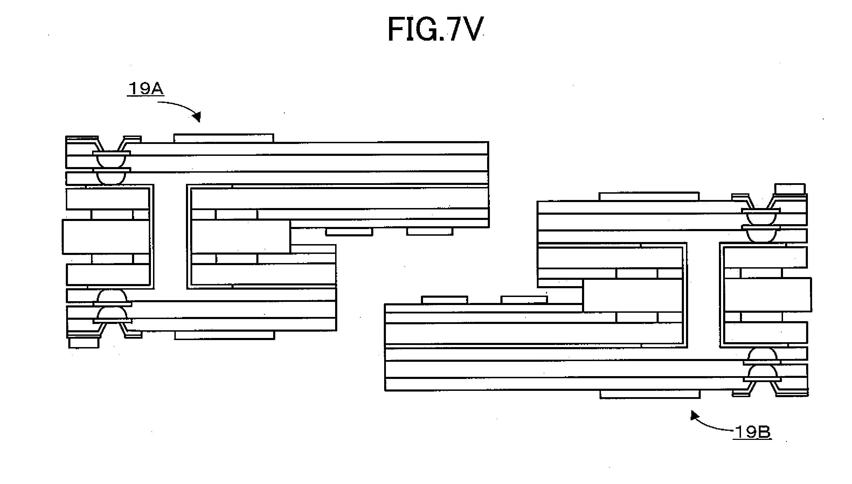

Further, as shown in Fig. 7V, wiring board (19A) and wiring board (19B) are used separately. In such a circumstance, since adhesion prevention layers 12 are formed, wiring board (19A) and wiring board (19B) may be separated by a simple process to be used separately. Regarding a wiring board according to the present invention, when an electronic device such as a cell phone receives an impact from dropping or the like, connection breakage of electronic components or the like mounted in the wiring board may be prevented. Also, when being shipped to a user, the wiring board may be handled compactly, and when being used by the user, the combined wiring boards may be separated easily.

### (Second embodiment of a wiring board according to a specific example of the present invention)

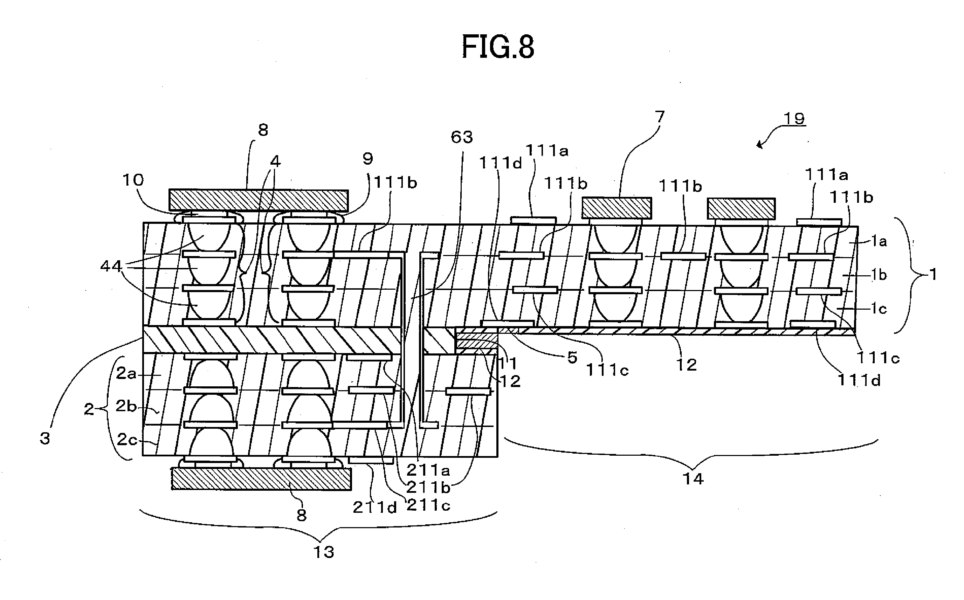

As shown in Fig. 8, in the Second Embodiment, at the portion where adhesion prevention layer 12 is made flush with the edge of second substrate 2, opening 5 is formed. The rest of the structure is the same as in the First Embodiment. Under opening 5, part of wiring pattern (111d) is positioned. Inside the groove formed with opening 5 and wiring pattern (111d) placed underneath is an aperture. The groove may be filled with elastic material such as silicon gel or silicon oil or viscous material. When wiring board 19 receives an impact from dropping, the aperture inside the groove or silicon gel or silicon oil filled in the groove cushions the impact as a buffer layer. Therefore, by making such a structure, drop impact resistance may be improved.

Also, if solid material or the like is filled in opening 5, the filled solid material or the like may play a role in decreasing warping at the boundary portion of multi-layer section 13 and fewer-layer section 14 where the number of layers is reduced. Accordingly, at the boundary portion of multi-layer section 13 and fewer-layer section 14, cracks may be prevented. Furthermore, if opening 5 is filled with, for example, solid material such as resin, the filled solid material plays a role in protecting conductive pattern (111d) mounted on first substrate 1. Therefore, corrosion resistance of conductive pattern (111d) may be improved.

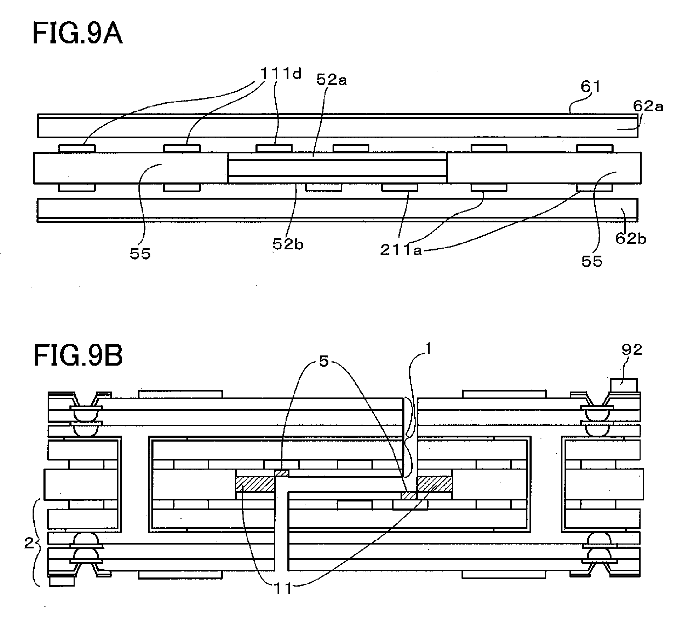

The method of manufacturing a wiring board according to the Second Embodiment is the same as the method of manufacturing a wiring board according to the First Embodiment in reference to Figs. 7A-7F, Figs. 7H-7T and 7V. Instead of Fig. 7G, as shown in Fig. 9A, cut-out dummy cores (52a, 52b) are placed in a way so that conductive pattern (111d) and conductive pattern (211 a) are laminated facing outward. Moreover, instead of Fig. 7U, as shown in Fig. 9B, opening 5 is filled with viscous material such as silicon oil.

### (Third embodiment of a wiring board according to a specific example of the present invention)

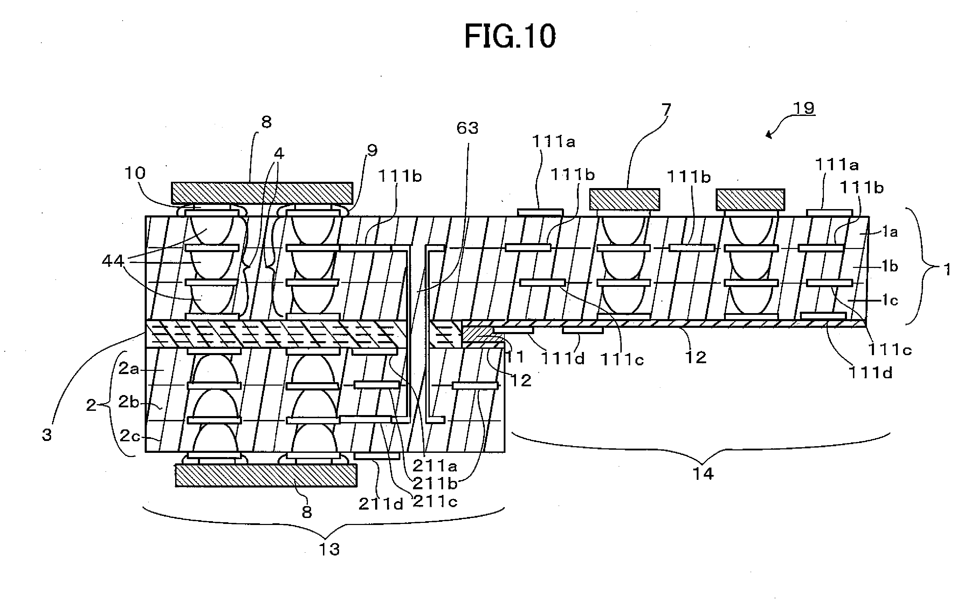

In the First Embodiment, base substrate 3 was made of glass-epoxy resin. However, as shown in Fig. 10, in the Third Embodiment, base substrate 3 is made containing base material of resin-impregnated inorganic fiber. By being structured as such, since base substrate 3 contains base material of resin-impregnated inorganic fiber, flex resistance may be improved.

The base material made of resin-impregnated inorganic fiber is formed by setting a prepreg. Prepreg is made by impregnating glass-cloth of inorganic fiber with epoxy resin, then preliminarily thermosetting the resin to advance the level of setting. The resin used to form the prepreg is preferred to have low-flow characteristics. However, those having regular flow characteristics may be used as well. Also, the prepreg may be formed by reducing the amount of epoxy-resin impregnated in the glass-cloth of inorganic fiber.

As for the inorganic fiber, it is not limited to glass-cloth, but for example, alumina fiber, carbon fiber (carbon fiber), silicon carbide fiber or silicon nitride fiber may be used.

In the method of manufacturing a wiring board according to the Third Embodiment, referring to Fig. 7D, as the material to form core 55, base material of resin-impregnated inorganic fiber is used. The rest is the same as the method of manufacturing a wiring board according to the First Embodiment.

### (Fourth embodiment of a wiring board according to a specific example of the present invention)

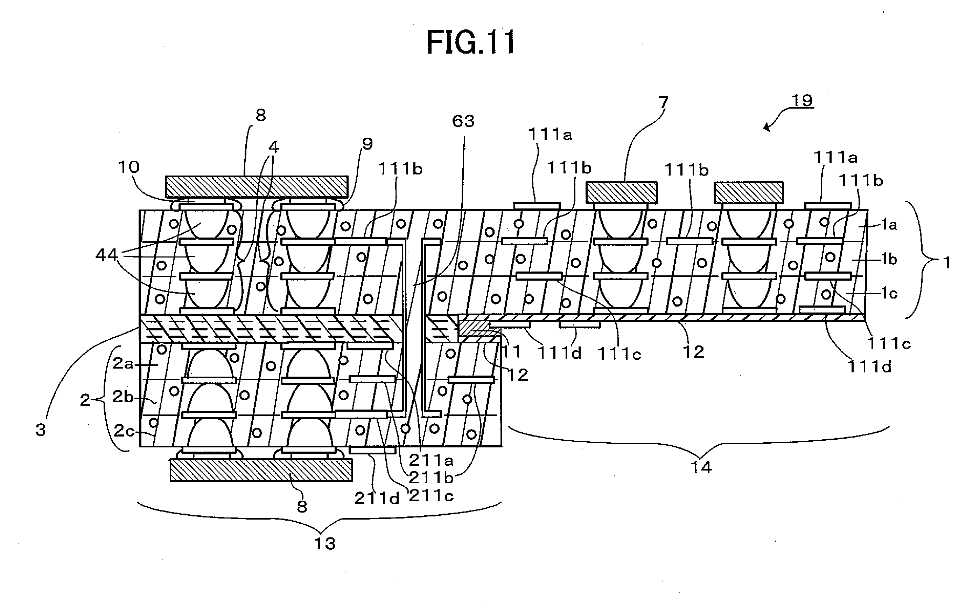

In the above-described First Embodiment, base substrate 3 was made of glass-epoxy resin. First substrate 1 and second substrate 2 are made of epoxy resin. However, the combination of material for base substrate 3 and material for first substrate 1 and second substrate 2 is not limited to the above. As shown in Fig. 11, in the Fourth Embodiment, base substrate 3 is made containing base material of resin-impregnated inorganic fiber; and first substrate 1 and second substrate 2 are made containing inorganic filler composite resin. By structuring such, since base substrate 3 contains base material of resin-impregnated inorganic fiber, flex resistance may be improved. Accordingly, when an electronic device such as a cell phone receives an impact from dropping or the like, a disconnection of the wiring connecting electronic components mounted in the wiring board may be prevented.

An inorganic filler composite resin may be made by combining silica filler or glass filler with epoxy resin. In addition to epoxy resin, or other than epoxy resin, polyimide, polycarbonate, polybutylene-terephthalate or polyacrylate may be used.

For silica filler, fused silica (SiO₂) or crystalline silica (SiO₂) may be used. Also, for glass filler, aluminum oxide (Al₂O₃), magnesium oxide (MgO), or boron nitride (BN), aluminum nitride (AlN) may be used. Furthermore, for inorganic filler, it is not limited to silica filler or glass filler, but antimony trioxide, antimony pentaxide or magnesium hydroxide may be used.

In the method of manufacturing a wiring board according to the Fourth Embodiment, referring to Fig. 7D, as the material to form core 55, base material of resin-impregnated inorganic fiber is used. In addition, referring to Figs. 7G, 7K and 7O, for the resin to be laminated, inorganic filler composite resin is used. The rest is the same as the method of manufacturing a wiring board according to the First Embodiment.

### (Fifth embodiment of a wiring board according to a specific example of the present invention)

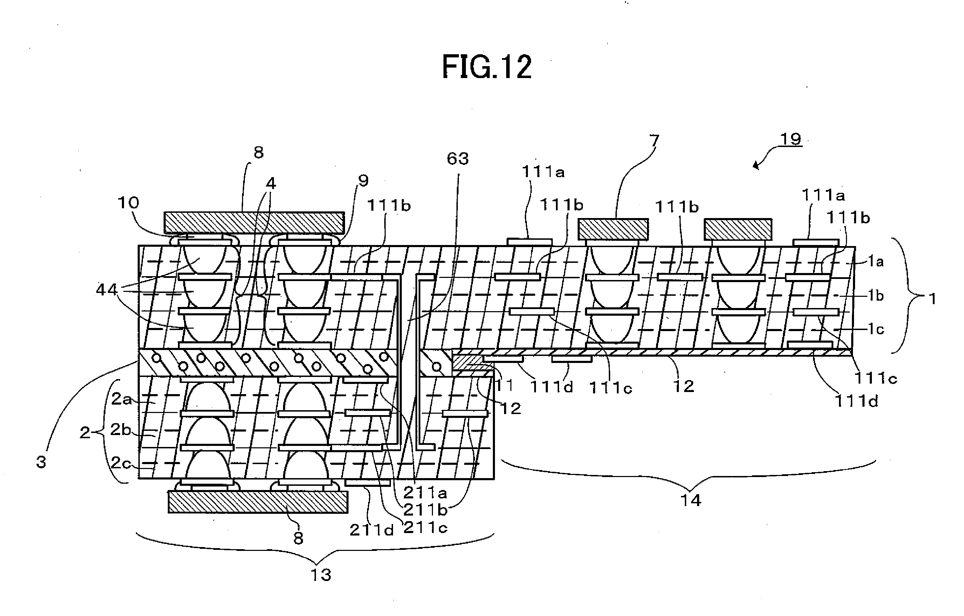

In the above-described First Embodiment, base substrate 3 was made of glass-epoxy resin. And first substrate 1 and second substrate 2 were made of epoxy resin. However, the combination of material for base substrate 3 and material for first substrate 1 and second substrate 2 is not limited to the above. As shown in Fig. 12, in the Fifth Embodiment, base substrate 3 is made containing inorganic filler composite resin; and first substrate 1 and second substrate 2 are made containing base material of resin-impregnated inorganic fiber. By structuring such, since at least either first substrate 1 or second substrate 2 is reinforced with inorganic fiber, flex resistance may be improved. Accordingly, when an electronic device such as a cell phone receives an impact from dropping or the like, a disconnection of the wiring connecting electronic components mounted in the wiring board may be prevented.

Above-described inorganic material such as inorganic fiber or inorganic filler has small coefficient of thermal expansion and low elasticity compared with resin of an organic material. Therefore, when inorganic material such as inorganic fiber or inorganic filler is combined, alignment gaps between connecting lands may be reduced.

In the method of manufacturing a wiring board according to the Fifth Embodiment, referring to Fig. 7D, as the material to form core 55, inorganic filler composite resin is used. In addition, referring to Figs. 7G, 7K and 7O, as the material to be laminated, base material of resin-impregnated inorganic fiber is used. The rest is the same as the method of manufacturing a wiring board according to the First Embodiment.

### (OTHER EXAMPLES OF THE PRESENT INVENTION)

In a wiring board according to the First Embodiment of the present invention, first substrate 1 and second substrate 2 are in a stratum structure having a rectangular outline. However, they are not limited to such, but may be in a layered structure having a circular, hexagonal, or octagonal outline.

Also, in the First Embodiment, first substrate 1 and second substrate 2 are made of epoxy resin. However, first substrate 1 and second substrate 2 are not limited to such, but may be made of polyimide, polycarbonate, polybutylene-terephthalate or polyacrylate. In addition, if first substrate 1 and second substrate 2 are made of epoxy resin, naphthalene-type epoxy resin, dicyclopentadiene-type epoxy resin, biphenyle-type epoxy resin or bisphenol-type epoxy resin may be used.

In the First Embodiment, as solder 9, Sn/Ag/Cu was used. However, solder 9 is not limited to such; solder containing antimony, tin, lead, indium or copper may be used. Also, eutectic metals such as Sn/Sb, Sn/Ag, Sn/Pb or Sb/Cu may be used as well. Among such eutectic metals, to avoid having a bad influence on the substrates, using those having relatively low melting temperatures, 250°C or lower, is preferred.

In the First Embodiment, in interlayer groove portion 11, silicon gel of viscous silicon is filled. However, filling interlayer groove portion 11 is not limited to such, and solid material may also be used. As solid material to be filled in interlayer groove portion 11, high-polymer rubber being a solid material with viscosity and elasticity is preferred. Specifically, butyl-rubber, isoprene rubber, butadiene rubber, styrene-butadiene rubber or ethylene-propylene rubber may be used. Moreover, interlayer groove portion 11 may be filled with a gas. As the gas to be filled in interlayer groove portion 11, rare gas such as argon or nitrogen, or oxygen may be used.

In the Second Embodiment, in opening 5, silicon gel of viscous silicon is filled. However, the material to be filled in opening 5 is not limited to such, but solid material may be filled in opening 5. As solid material to be filled in opening 5, high-polymer rubber being solid material having viscosity and elasticity is preferred. Specifically, butyl-rubber, isoprene rubber, butadiene rubber, styrene-butadiene rubber or ethylene-propylene rubber may be used. As the material to be filled in opening 5, liquid or solid material is preferred, but gas may also be filled. In such a case, as the gas to be filled in opening 5, rare gas such as argon or nitrogen, or oxygen may be used.

In addition, first substrate 1 may not need to be formed single-layered, but may be formed multi-layered. Namely, first substrate 1 may be structured with a lower-layer insulation layer and an upper-layer insulation layer. Here, a lower-layer insulation layer indicates the insulation layer formed close to base substrate 3; and an upper-layer insulation layer indicates an insulation layer formed on the outer surface of the wiring board. Furthermore, first substrate 1 may be structured with a lower-layer insulation layer, an upper-layer insulation layer and an intermediate insulation layer placed in between. The intermediate insulation layer may be made multi-layered. In the First Embodiment, the lower-layer insulation layer corresponds to epoxy-resin layer (1c), the intermediate insulation layer corresponds to epoxy-resin layer (1b) and the upper-layer insulation layer corresponds to epoxy-resin layer (1a).

Also, the second substrate may not need to be formed single layered, but may be formed multi-layered. And second substrate 2 may also be structured with a lower-layer insulation layer and an upper-layer insulation layer. Furthermore, second substrate 2 may be structured with a lower-layer insulation layer, an upper-layer insulation layer and an intermediate insulation layer placed in between. In the First Embodiment, the lower-layer insulation layer corresponds to epoxy-resin layer (2a), the intermediate insulation layer corresponds to epoxy-resin layer (2b) and the upper-layer insulation layer corresponds to epoxy-resin layer (2c). On top of the upper-layer insulation layer and lower-layer insulation layer, conductive patterns are formed. And, those conductive patterns may be connected with each other through vias 44.

### Industrial Applicability

The present invention may be employed in a wiring board which can mount electronic components, specifically, in a wiring board which can mount electronic components for a compact electronic device.

## Claims

1. A wiring board comprising:
a first substrate;
a second substrate having a smaller mounting area than that of the first substrate; and
a base substrate laminated between the first substrate and the second substrate, wherein
vias are formed at least either in the first substrate or the second substrate.

2. The wiring board according to Claim 1, wherein an interlayer groove portion is formed between the first substrate and the second substrate, and in the interlayer groove portion, at least one of gas, liquid, or solid material is filled.

3. The wiring board according to Claim 1, wherein a warping prevention portion is formed at a stepped portion created when the first substrate and the second substrate are laminated.

4. The wiring board according to Claim 1, wherein an opening is made at the stepped portion created when the first substrate and the second substrate are laminated, and in the opening, at least one of gas, liquid, or solid material is filled.

5. The wiring board according to Claim 1, wherein the base substrate is made containing base material of resin-impregnated inorganic fiber, the first substrate is made containing at least either inorganic filler composite resin or pliable resin, and the second substrate is made containing at least either inorganic filler composite resin or pliable resin.

6. The wiring board according to Claim 5, wherein the inorganic fiber contains glass cloth.

7. The wiring board according to Claim 5, wherein the inorganic filler contains at least either silica filler or glass filler.

8. The wiring board according to Claim 1, wherein the base substrate is made containing inorganic filler composite resin, and at least either the first substrate or the second substrate is made containing base material of resin-impregnated inorganic fiber.

9. The wiring board according to Claim 8, wherein the inorganic fiber contains glass cloth.

10. The wiring board according to Claim 8, wherein the inorganic filler contains at least either silica filler or glass filler.

11. The wiring board according to Claim 1, wherein on the first substrate, a conductive pattern is formed; on the second substrate, a conductive pattern is formed; and the conductive pattern on the first substrate and the conductive pattern on the second substrate are connected with a through-hole.

12. The wiring board according to Claim 1, wherein on the inner surface of the via, a conductive layer is formed by plating, and the via is filled with metal.

13. The wiring board according to Claim 1, wherein on the inner surface of the via, a conductive layer is formed by plating, and the via is filled with resin.

14. The wiring board according to Claim 1, wherein the first substrate is structured including a lower-layer insulation layer and an upper-layer insulation layer, and the second substrate is structured including a lower-layer insulation layer and an upper-layer insulation layer.

15. The wiring board according to Claim 14, wherein on the upper-layer insulation layer, a conductive pattern is formed; on the lower-layer insulation layer, a conductive pattern is formed; and the conduct pattern on the upper-layer insulation layer and the conductive pattern on the lower-layer insulation layer are connected through vias.

16. A method of manufacturing a wiring board comprising:
a base-substrate forming step to form a base substrate;
an insulation-layer forming step to form insulation layers on both surfaces of the base substrate;
a via forming step to form vias in the insulation layer(s); and
a cutting step to form a first substrate and a second substrate having a smaller mounting area than that of the first substrate by cutting the insulation layer(s).

17. The method of manufacturing a wiring board according to Claim 16, further comprising an interlayer groove portion forming step to form an interlayer groove portion between the first substrate and the second substrate, and a filling step to fill at least one of gas, liquid, or solid material in the interlayer groove portion.

18. The method of manufacturing a wiring board according to Claim 16, further comprising a warping prevention portion forming step to form a warping prevention portion at the stepped portion created when the first substrate and the second substrate are laminated.

19. The method of manufacturing a wiring board according to Claim 16, further comprising an opening forming step to form an opening at the stepped portion created when the first substrate and the second substrate are laminated, and a filling step to fill at least one of gas, liquid, or solid material in the opening.

20. The method of manufacturing a wiring board according to Claim 16, wherein the base substrate is made containing base material of resin-impregnated inorganic fiber, the first substrate is made containing at least either inorganic filler composite resin or pliable resin, and the second substrate is made containing at least either inorganic filler composite resin or pliable resin.

21. The method of manufacturing a wiring board according to Claim 20, wherein the inorganic fiber contains glass cloth.

22. The method of manufacturing a wiring board according to Claim 20, wherein the inorganic filler contains at least either silica filler or glass filler.

23. The method of manufacturing a wiring board according to Claim 16, wherein the base substrate is made containing inorganic filler composite resin, and at least either the first substrate or the second substrate is made containing base material of resin-impregnated inorganic fiber.

24. The method of manufacturing a wiring board according to Claim 23, wherein the inorganic fiber contains glass cloth.

25. The method of manufacturing a wiring board according to Claim 23, wherein the inorganic filler contains at least either silica filler or glass filler.

26. The method of manufacturing a wiring board according to Claim 16, wherein on the first substrate, a conductive pattern is formed; on the second substrate, a conductive pattern is formed; and the conductive pattern on the first substrate and the conductive pattern on the second substrate are connected with a through-hole.

27. The method of manufacturing a wiring board according to Claim 16, wherein on the inner surface of the via, a conductive layer is formed by plating, and the via is filled with metal.

28. The method of manufacturing a wiring board according to Claim 16, wherein on the inner surface of the via, a conductive layer is formed by plating, and the via is filled with resin.

29. The method of manufacturing a wiring board according to Claim 16, wherein the first substrate is structured including a lower-layer insulation layer and an upper-layer insulation layer, and the second substrate is structured including a lower-layer insulation layer and an upper-layer insulation layer.

30. The method of manufacturing a wiring board according to Claim 29, wherein on the upper-layer insulation layer, a conductive pattern is formed; on the lower-layer insulation layer, a conductive pattern is formed; and the conductive pattern on the upper-layer insulation layer and the conductive pattern on the lower-layer insulation layer are connected through vias.
